# EUROPÄISCHE PATENTSCHRIFT

(11) **EP 1 032 519 B1**
(45) Veröffentlichungstag und Bekanntmachung des Hinweises auf die Patenterteilung: **14.08.2002**
(21) Anmeldenummer: 98962371.5
(22) Anmeldetag: 20.11.1998
(51) Int. Cl.: B60T 13/72

(54) **BESCHALTUNG FÜR EIN STELLGLIED UND VERFAHREN ZUM ÜBERPRÜFEN DER BESCHALTUNG EINES STELLGLIEDS**
PROTECTIVE CIRCUIT FOR A CONTROLLING ELEMENT AND METHOD FOR TESTING THE CONTROL CIRCUIT OF A CONTROLLING ELEMENT
CABLAGE POUR UN COMPOSANT DE REGLAGE, ET PROCEDE DE CONTROLE DE CE CABLAGE DE COMPOSANT DE REGLAGE

(30) Priorität: 21.11.1997 DE 19751606; 21.11.1997 DE 19751602; 16.06.1998 DE 19826685
(43) Veröffentlichungstag der Anmeldung: 06.09.2000
(73) Patentinhaber: Continental Teves AG & Co. oHG, 60488 Frankfurt am Main (DE)
(72) Erfinder: PEICHL, Thomas, D-61206 Wöllstadt (DE); MÖHEKEN, Gerhard, D-61250 Usingen (DE); SCHÖNBEIN, Artur, D-60385 Frankfurt am Main (DE)
(86) Internationale Anmeldenummer: EP9807469
(87) Internationale Veröffentlichungsnummer: WO9926827

(56) Entgegenhaltungen:
- WO-A-96/11129
- US-A- 5 010 972
- US-A- 5 083 075

## Beschreibung

Die Erfindung betrifft einen elektrisch steuerbaren Bremskraftverstärker sowie ein Verfahren zur Überprüfung der Beschaltung eines Stellglieds eines elektronisch gesteuerten Bremskraftverstärkers gemäß den Oberbegriffen der unabhängigen Ansprüche.

In der DE-OS 44 25 578 ist schematisch ein Bremssystem mit einem elektrisch steuerbaren Bremskraftverstärker gezeigt. Hierbei ist jedoch nicht angegeben, wie eine einerseits zuverlässige und andererseits für das Bremsverhalten des Fahrzeugs unkritische Überprüfung der Komponenten der elektrischen Ansteuerung des Ventils erfolgen kann.

Aus der US-A-5 083 075 ist ein Bremssystem mit einem elektrisch steuerbaren Bremskraftverstärker mit einem zwischen zwei Potentiale schaltbaren, mit zwei Anschlüssen versehenen Stellglied, mit einer Beschaltung für das Stellglied, mit einer ersten und einer zweiten Leitung, die die zwei Potentiale den Anschlüssen zuführen, einem in der ersten Leitung vorgesehenen, elektronisch betätigbaren Schalter zwischen dem ersten Potential und dem ersten Anschluß des Stellgliedes, sowie einer Steuereinrichtung, die den Schalter mit einem pulsbreitenmodulierten Steuersignal schaltet.

Aufgabe der Erfindung ist es, eine Beschaltung für ein Stellglied bzw. ein Verfahren für die Überprüfung der Beschaltung eines Stellglieds weiter zu entwickeln, um eine bessere Fehlerüberwachung zu ermöglichen.

Diese Aufgabe wird mit den in den kennzeichnenden Teilen aufgeführten Merkmalen der unabhängigen Ansprüche gelöst. Abhängige Ansprüche sind auf bevorzugte Ausführungsformen der Erfindung gerichtet.

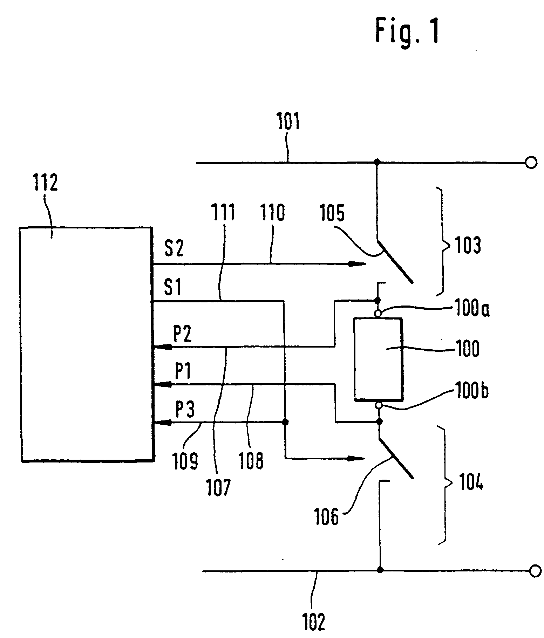

Bevor einzelne Ausführungsformen der Erfindung beschrieben werden, werden anhand von Fig. 1 mögliche Fehlerfälle beschrieben. Fig. 1 zeigt mit Bezugsziffer 100 das betrachtete Stellglied bzw. dessen elektrische Komponente, insbesondere beispielsweise einen Elektromagneten, eine Spule, einen Elektromotor oder ähnliches. Das Stellglied weist zwei Anschlüsse 100a und 100b auf. Dieses Stellglied kann mittels seiner Anschlüsse 100a, 100b zwischen zwei Potentiale 101, 102 geschaltet werden. Bei 102 kann es sich beispielsweise um Masse handeln, bei 101 um die Batterieversorgungsspannung (üblicherweise 12 V) oder eine andere geeignete Spannung. In herkömmlichen Anlagen wird der Betriebs des Stellglieds 100 mittels eines Schalters gesteuert: Das Stellglied arbeitet, wenn der Schalter geschlossen ist, und es ruht, wenn der Schalter offen ist. Es können verschiedene Fehler auftreten:

Der Schalter kann kurzgeschlossen oder nicht mehr schließbar sein. Einer der Anschlüsse 100a, 100b des Stellglieds 100 kann nach einem der Potentiale 101, 102 kurzgeschlossen sein. Das Stellglied 100 kann intern eine Unterbrechung oder einen Kurz-schluß aufweisen. Schließlich können über hochohmige Nebenschlüsse Leckströme zu den genannten Potentialen hin auftreten. Die meisten der obengenannten Fehler stellen einen die Funktion des Stellglieds unmittelbar beeinträchtigenden Fehler dar, der frühestmöglich erkannt werden muß, um unsichere Betriebszustände weitestgehend vermeiden zu können.

Wünschenswert ist damit eine Beschaltung, die ein häufiges Überprüfen des Stellglieds erlaubt. Insbesondere soll eine Überprüfung auch dann möglich sein, wenn das Stellglied potentiell benützt werden kann, also beispielsweise während der Fahrt eines Kraftfahrzeugs. Andererseits ist sicherzustellen, daß die Überprüfung dann nicht zu unerwünschten Eingriffen führt, beispielsweise unerwünschten Bremseingriffen.

Erfindungsgemäß wird deshalb eine Beschaltung angegeben, die zwei elektronisch betätigbare Schalter an jedem der Anschlüsse des Stellglieds aufweist. Bei der herkömmlichen Betätigung des Stellglieds kann einer der Schalter fest geschlossen und ein anderer der Schalter nach Maßgabe weiterer Regelungskriterien angesteuert werden. Im Überprüfungsbetrieb kann ein Schalter offen bleiben und ein anderer geschlossen werden, so daß auf-grund von Potentialverhältnissen Fehler erkannt werden können.

Bezug nehmend auf die Zeichnungen werden nun einzelne erfindungsgemäße Ausführungsformen beschrieben, es zeigen
- Fig. 1: schematisch eine erste erfindungsgemäße Ausführungsform,
- Fig. 2: schematisch eine weitere erfindungsgemäße Ausführungsform,
- Fig. 3: verschiedene Fehlerzustände und die Art ihrer Erkennung in tabellarischer Form, und
- Fig. 4: eine Ausführungsform einer Überprüfungseinrichtung.

Fig. 1 zeigt eine erste erfindungsgemäße Ausführungsform. 100 ist das Stellglied bzw. die elektrische Komponente dazu, beispielsweise ein Elektromagnet, eine Spule, ein Elektromotor oder ähnliches. Es weist Anschlüsse 100a und 100b auf. An je einer Seite des Stellglieds 100 ist ein Schalter 105, 106 vorgesehen. Schalter 105 liegt in der Leitung 103 zwischen Anschluß 100a und Potential 101, während Schalter 106 in der Leitung 104 zwischen Anschluß 100b und Potential 102 liegt. Bei den Schaltern 105, 106 handelt es sich vorzugsweise um elektronisch betätigbare Schalter, beispielsweise FETs, Leistungs-FETs, Thyristoren, GTOs oder ähnliches. Die Schalter 105, 106 werden nach Maßgabe von Steuerungssignalen S1, S2 geschaltet, die über Leitungen 111, 110 den Schaltern zugeführt werden. Im herkömmlichen Betrieb des Stellglieds (beispielsweise leichte Bremsung) kann beispielsweise so verfahren werden, daß Schalter 105 über Leitung 110 ein Steuerungssignal S2 zugeführt bekommt, so daß er dauerhaft schließt. Schalter 106 bekommt dagegen ein Signal S1 über Leitung 111 zugeführt, so daß das Stellglied 100 in gewünschter Weise betätigt wird. Beispielsweise kann das Signal S1 ein nach Maßgabe der gewünschten Bremskraft erzeugten pulsbreitenmoduliertes Signal sein. Dadurch wird der elektronisch betätigbare Schalter 106 vergleichsweise hochfrequent geöffnet und geschlossen, so daß sich durch das Stellglied 100 ein gewünschter mittlerer Strom einstellt. Anstelle eines pulsbreitenmodulierten Signals können aber auch andere Signale vorgesehen sein, beispielsweise ein analoges Signal, das den Schalter 106 analog schaltet, also mehr oder minder weit öffnet, um beispielsweise einen gewünschten Strom einzustellen.

Weiterhin sind eine oder mehrere der nachfolgend beschriebenen Prüfsignalrückführungen zur Überprüfung elektrischer Werte bzw. von Zeitverhältnissen vorgesehen: Prüfsignal P1 auf Leitung 108, das in der Nähe des Anschlusses 100b des Stellglieds 100 abgegriffen wird, Prüfsignal P2 auf Leitung 107, das in der Nähe des Anschlusses 100a des Stellglieds 100 abgegriffen wird, und Prüfsignal 109, das dem ersten Steuersignal entspricht.

Wenn eine Überprüfung des Stellglieds 100 bzw. seiner Beschaltung erfolgen soll, können dann zunächst die Schalter 105, 106 in geeigneter Weise betätigt und dann die Prüfsignale P1 bis P3 auf den Signalleitungen 107 bis 109 überprüft werden.

Verschiedene Prüfmodi können zur Überprüfung der vorher genannten Fehlermöglichkeiten eingestellt werden, beispielsweise Modus 0, in dem beide Schalter 105, 106 offen sind, Modus 1, in dem ein Schalter geschlossen und ein anderer geöffnet ist (so daß das Stellglied immer noch elektrisch nicht betätigt wird), und Modus 2, in dem ein Schalter geschlossen und der andere so kurzzeitig geschlossen wird, daß keine nennenswerte Betätigung des Stellglieds erfolgt.

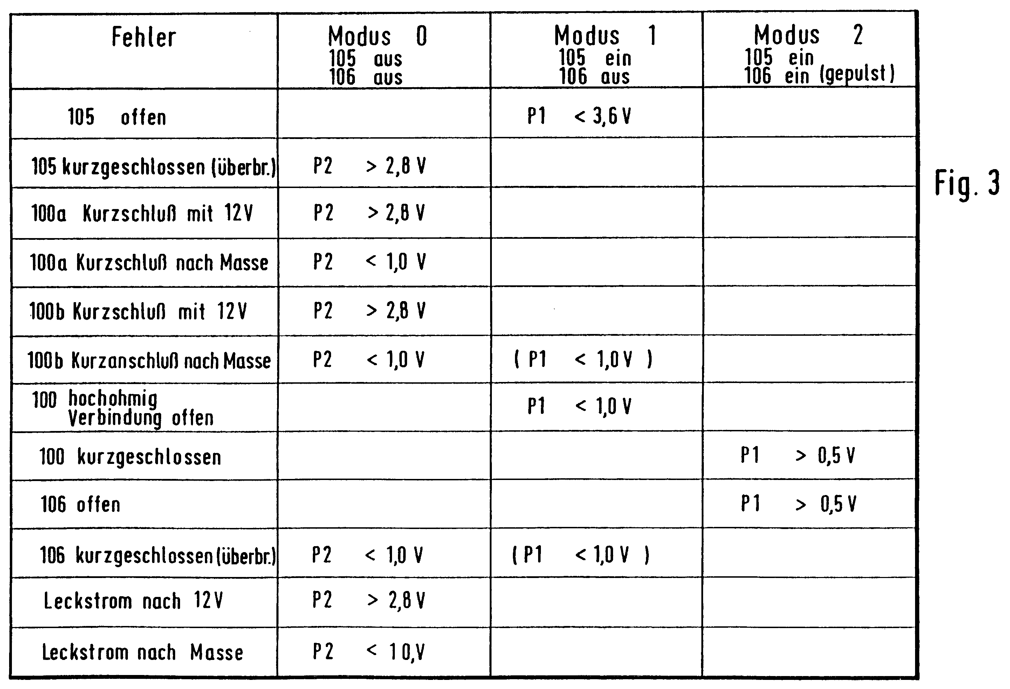

Bezug nehmend auf Fig. 3 werden diese Moden später genau erläutert.

Durch das Vorsehen zweier Schalter ist es möglich, beide Anschlüsse 100a, 100b des Stellglieds 100 von den jeweiligen Potentialen 101, 102 abzutrennen (siehe oben Modus 0), so daß verschiedene Fehlerbedingungen erkannt werden können, die ohne dieses Abtrennen nicht oder nur schwer erkennbar wären. Durch das Vorsehen zweier Schalter kann außerdem einer geschlossen und ein anderer offengehalten werden, so daß weitere Fehler erkannt werden können (Modus 1), ohne daß ein Bremseingriff erfolgt.

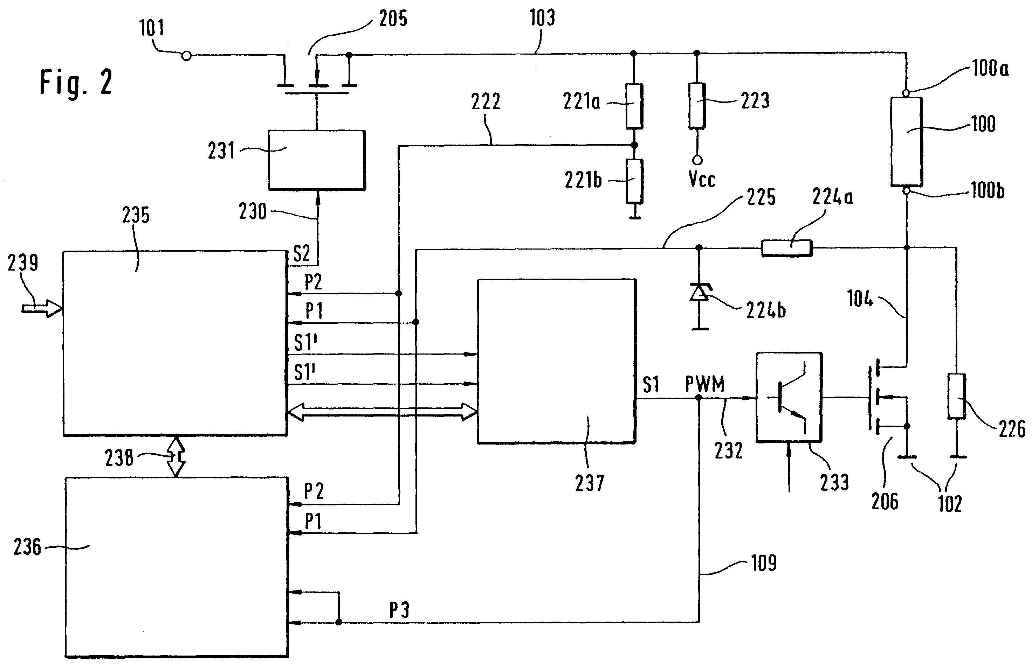

Bezug nehmend auf Fig. 2 wird eine detailliertere Ausführungsform beschrieben, wobei gleiche Bezugszeichen wie in Fig. 1 gleiche Komponenten bedeuten. 205 ist ein als FET ausgebildeter Schalter und entspricht dem Schalter 105 in Fig. 1, sinngemäß das gleiche gilt für Schalter 206. Zur Ansteuerung sind jeweils Treiberschaltungen 231, 233 vorgesehen.

Die Signale S1, S2, nach deren Maßgabe die Schalter 205, 206 gesteuert werden, werden durch eine Steuerschaltung 112, 235 - 237 in geeigneter Weise erzeugt. Die Komponenten 235 - 237 in Fig. 2 entsprechen dabei im wesentlichen der Steuerschaltung 112 in Fig. 1. Das erste Steuersignal S1 wird durch Leitung 109 als Prüfsignal P3 in eine Signalüberwachungsschaltung 236 zurückgeführt. Genauso werden die Potentiale in der Nähe der Anschlüsse 100a, 100b des Stellglieds abgegriffen und über Rückführungen 221, 222 bzw. 224, 225 als Prüfsignale P1, P2 in die Signalüberwachungsschaltung 236 zurückgeführt. Die Widerstände 221a und 221b wirken als Spannungsteiler, die der Wertanpassung des Signalpegels P2 dienen. Die Widerstände 223 und 226 sind vergleichsweise hochohmig und ziehen die Klemmen 100a, 100b des Stellglieds 100 auf definierte Werte, wenn die Schalter 205, 206 offen sind. Zusammen wirken die Widerstände 223, 226 mit dem ohm'sehen Widerstand der Spule 100 ebenfalls als Spannungsteiler.

235 ist eine Verarbeitungseinrichtung, die höherrangige Signale 239 empfängt und nach Maßgabe dieser Signale ein erstes Ausgangssignal S1' erzeugt, das als Eingangssignal einer Erzeugungseinrichtung 237 dient. Die Erzeugungseinrichtung 237 erzeugt das eigentliche erste Steuersignal S1, das vorzugsweise pulsbreitenmoduliert und digital ist. Es kann aber auch ein Analogsignal sein, das einen Transistor mehr oder minder weit öffnet.

Die Verarbeitungseinrichtung 235 kommuniziert mit der Signalüberwachungseinrichtung 236 über Datenleitungen 238.

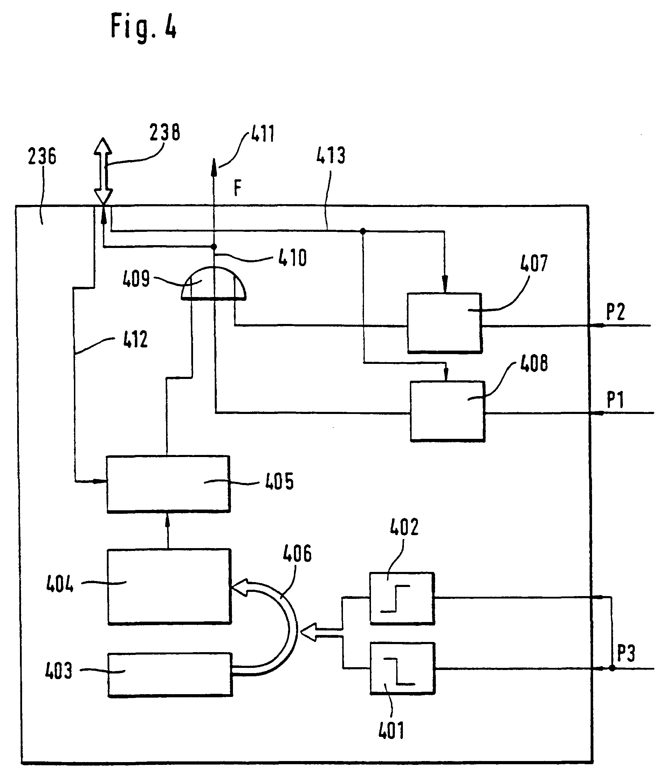

Die Überwachungseinrichtung 236, deren genauerer Aufbau Bezug nehmend auf Fig. 4 später erläutert wird, kann zum einen die Signalpegel auf den Leitungen P1 und P2 überwachen. Zum anderen kann sie das Steuerungssignal S1 auf Richtigkeit überprüfen. Wenn das Steuersignal S1 beispielsweise ein pulsbreiten-moduliertes Signal ist, kann die Verarbeitungseinrichtung 235 Schalter 205 geöffnet halten und für Schalter 206 ein pulsbreitenmoduliertes Signal S1 mit bekanntem Tastverhältnis erzeugen. Die Überwachungseinrichtung 236 überprüft dann, ob das Signal S1 in der erwarteten Weise erzeugt wird, beispielsweise in dem (bei pulsbreitenmodulierten Signalen) die zeitliche Lage von Flanken überprüft wird oder (beispielsweise bei einem analogen Steuerungssignal) der Pegel des Signals überprüft wird.

Anhand von Fig. 3 werden nun verschiedene Fehlerbedingungen und die Art ihrer Ermittlung beschrieben. Die angegebenen Schwellenwerte sind beispielhaft zu verstehen, sie ergeben sich aus der Dimensionierung der einzelnen Widerstände in der Schaltung der Fig. 2. Die in Fig. 3 betrachteten Fehler betreffen dabei Fehler in der Beschaltung des Stellglieds bzw. im Stellglied selber, die anhand der Prüfsignale P1, P2 erkannt werden können. Während der Überprüfung können die weiter oben genannten Moden eingestellt werden. Im Modus 0 sind beide Schalter 105, 106, bzw. 205, 206 offen, sofern sie ordnungsgemäß arbeiten. Über die Widerstände 223 bzw. 226 werden die Anschlüsse 100a bzw. 100b des Stellglieds 100 auf definierte Potentiale gezogen, die anders sind als die Potentiale 101, 102. Wenn einer der Schalter kurzgeschlossen ist, kann dies daran erkannt werden, daß an den Klemmen 100a, 100b trotz des theoretisch offenen Schalters 205, 206 das Potential 101 bzw. 102 anliegt. In ähnlicher Weise können Kurzschlüsse des Anschlusses 100a nach Masse 102 bzw. des Anschlusses 100b hin zur Versorgungsspannung erkannt werden. Ein Massekurzschluß des Anschlusses 100a wird an einem sehr niedrigen Potential an diesen Anschluß erkennbar. Andersherum läßt sich der Kurzschluß es Anschlusses 100b zur Versorgungs-spannung hin an einem sehr hohen Potential sowohl am Anschluß 100b als auch am Anschluß 100a erkennen. In diesem Zusammenhang wird darauf hingewiesen, daß es nicht zwangsläufig notwendig ist, einzelne Fehler voneinander zu unterscheiden. Wichtig ist, daß geeignete Maßnahmen ausgelöst werden, sobald irgendein Fehler vorliegt, wobei es auf die genaue Art des Fehlers dann nicht ankommt.

In ähnlicher Weise wie Kurzschlüsse eines Anschlusses 100a, 100b hin zu einem der Potentiale können Leckströme ermittelt werden, wenn beide Schalter offen sind. Auch solche Leckströme haben Auswirkungen auf die Potentiale an den Klemmen, so daß diese durch geeignete Schwellenwerteinstellungen und Über-prüfung des Potentials auf den Leitungen 222, 225 ermittelt werden können.

Im Modus 1 kann beispielsweise Schalter 105, 205 geschlossen und Schalter 105, 206 offen sein. Hierdurch kann erkannt werden, ob Schalter 105, 205 schließt. Wen nicht, wird das Potential an Klemme 100a nicht den geforderten Wert einnehmen, so daß sich dies über Spannungsteiler 221a, b und Leitung 222 in Form des Prüfsignals P2 der Signalüberwachungseinrichtung 236 mitteilt. Der (schon im Modus 0) erkennbare Massekurzschluß des Anschlusses 100b des Stellglieds 100 läßt sich an einem sehr niedrigen Pegel des Prüfsignals P1 erkennen. Das gleiche gilt für eine Unterbrechung der Spule selbst. Das hohe Potential 101, das sich über geschlossenen Schalter 205 dem Anschluß 100a mitteilt, wird am Anschluß 100b nicht sichtbar, so daß das Prüfsignal P1 unter einem Schwellenwert bleibt.

Wie schon im Modus 0 wird schließlich ein Kurzschluß des Schalters 206 erkennbar, weil dann der Anschluß 100b auf das niedrige Massenpotential 102 gezogen wird, obwohl Schalter 206 offen sein müßte.

Im Modus 2 schließlich sind beide Schalter 105, 106 bzw. 205, 206 geschlossen. Dieser Modus ist insofern kritisch, als dadurch das Stellglied mit Strom beaufschlagt und dadurch tatsächlich betätigt wird. Somit ist es vorteilhaft, diesen Modus nur sehr kurz einzustellen, beispielsweise indem Schalter 106, 206 zusätzlich zum schon geschlossenen Schalter 105, 205 nur sehr kurz geschlossen wird. In diesem Modus 2 wird das Nichtschalten des Schalters 106, 206 erkennbar, weil dann das Potential am Anschluß 100b nicht aus Masse gezogen wird, sondern über einem Schwellenwert verbleibt. Nach dem gleichen Kriterium kann ein Kurzschluß des Stellglieds 100 erkannt werden. Aufgrund des Kurzschlusses wird am Stellglied 100 nicht die erwartete Spannung abfallen, so daß abermals der Anschluß 100b kein massenahes Potential einnehmen wird, sondern über einem Schwellenwert verbleibt.

Die Bezug nehmend auf Fig. 3 beschriebenen Moden erlauben innerhalb eines Modus jeweils die Erkennung von Fehlerbedingungen Bezug benehmend jeweils auf nur eines der Prüfsignale P1 oder P2. So wird beispielsweise im Modus 2 das Prüfsignal P1 (das dem Potential am Anschluß 100b entspricht) mit einem ersten, vergleichsweise niedrigen Schwellenwert verglichen. Im Modus 0 wird das Prüfsignal P2 (das nach Maßgabe des Potentials am Anschluß 100a erzeugt wird) jeweils daraufhin überprüft, ob es niedriger als ein zweiter Schwellenwert liegt, der etwas höher als der erste Schwellenwert ist, bzw. ob es höher als ein dritter Schwellenwert ist, der höher als der zweite Schwellenwert ist. Im Modus 1 wird im wesentlichen das Prüfsignal P1 betrachtet und daraufhin überprüft, ob es über dem zweiten Schwellenwert liegt. Hier kann noch das Prüfsignal P2 auf Überschreitung eines vergleichsweise hohen vierten Schwellenwerts überprüft werden, um das ordnungsgemäße Schalten des Schalters 105, 205 feststellen zu können.

Die bisher beschriebenen Moden 1 - 3 dienen der Überprüfung der Beschaltung des Stellglieds bzw. des Stellglieds selbst. In einem weiteren Modus 3 (in Fig. 3 nicht gezeigt) kann das vergleichsweise komplexe erste Steuerungssignal S1 überprüft werden. Hierzu wird ein bestimmtes erstes Steuersignal S1 erzeugt und auf richtige Erzeugung hin überprüft. Um die tatsächliche Betätigung des Stellglieds 100 zu vermeiden, wird Schalter 105, 205 geöffnet. Die Steuerungseinrichtung 112, 235 - 237 erzeugt dann ein bestimmtes erstes Steuersignal S1, beispielsweise ein pulsbreitenmoduliertes Signal und überprüft das erzeugte Signal. Beispielsweise kann ein pulsbreiten-moduliertes Signal mit einem bestimmten Tastverhältnis erzeugt und dann überprüft werden, ob die Flanken dieses Signals in der gewünschten Weise erscheinen.

Um die erfindungsgemäß Überprüfung vornehmen zu können, weist die Steuerungseinrichtung 112, 235 - 237 und insbesondere die Verarbeitungseinrichtung 235 eine Testeinrichtung auf, die zum einen die notwendigen Steuersignale S1, S1', S2 zur Einstellung eines oder mehrerer der obengenannten Moden erzeugt und die zum anderen der Signalüberwachungseinrichtung 236 benötigte Steuersignale (beispielsweise Beginn und Ende der Überprüfung, zu erwartende Signalwerte bzw. zu überprüfende Schwellenwerte) mitteilt.

Außerdem kann eine Unterbrechungseinrichtung vorgesehen sein, die die beschriebene Überprüfung (insbesondere die Einstellung der Moden 0 - 3) unterbricht bzw. beendet, wenn eine An-forderung für eine tatsächliche Benützung des Stellglieds bei-spielsweise nach Maßgabe der Eingangssignale 239 erkennbar wird.

Fig. 4 zeigt eine Ausführungsform der Signalüberwachungseinrichtung 236. Im oberen Teil sind Einrichtungen zum Überprüfen der Prüfsignale P1, P2 (betreffend die Beschaltung des Stell-glieds bzw. das Stellglied selbst) gezeigt, der untere Teil zeigt Einrichtungen zur Überprüfung des ersten Steuerungs-signals S1, P3. Diese zwei Schaltungsteile können (wie gezeigt) kombiniert miteinander vorgesehen sein. Auch getrennte Ausführungsform und der Verzicht auf einen der beiden Teile sind möglich.

Wie schon anhand der Fig. 3 beschrieben, sind zur Überprüfung der Beschaltung sowie des Stellglieds selbst die Prüfsignale P1, P2 mit Schwellenwerten zu vergleichen. Hierzu weist die Signalüberwachungseinrichtung 236 zwei Vergleicher 407, 408 auf, die jeweils das eine oder das andere Signal überwachen. Da, wie in Fig. 3 gezeigt jedoch jeweils nur ein Fehlersignal zu überwachen ist, um die jeweiligen Fehler erkennen zu können, kann auch eine Ausführungsform vorgesehen sein, in der die beiden Fehlersignale P1, P2 durch einen Umschalter auf eine einzige Vergleichseinrichtung geleitet werden. Über Signalleitungen 413 können Schwellenwerte mitgeteilt werden sowie die Frage, ob auf Überschreitung bzw. Unterschreitung zu überprüfen ist. In einem Gatter 409 können die einzelnen Fehlersignale, die als Ausgang der Vergleichseinrichtungen 407, 408 entstehen, zu einem Fehlersignal F kombiniert werden, das separat als Signal 411 ausgegeben werden kann, oder das über den Strang 238 der Verarbeitungseinrichtung 235 mitgeteilt werden kann.

Der untere Teil der Fig. 4 zeigt eine Einrichtung zur Überprüfung eines pulsbreitenmodulierten Signals (das als Testsignal P3 eingegeben wird). Zunächst sind Flankendetektoren 401, 402 vorgesehen, wobei einer auf steigende und einer auf fallende Flanken anspricht. Daneben ist eine Zeitmeßeinrichtung 403 vorhanden. Immer dann, wenn eine Flanke detektiert wird, wird der gerade bestimmte Zeitpunkt in einen Speicher 404 mit mehreren Speicherplätzen seriell eingeschrieben. Dies ist durch Pfeil 406 schematisch angedeutet. In der Speichereinrichtung 404 findet sich demnach ein serieller Eintrag von Zeitpunkten, die abwechselnd den Zeitpunkt steigender und fallender Flanken kennzeichnen. Die Speichereinrichtung 404 kann beispielsweise nach Art eines Schieberegisters ausgebildet sein, in das fortwährend Daten eingeschrieben, nach Maßgabe später eingeschriebener Daten verschoben werden und schließlich herausfallen. Eine Auswerteeinrichtung 405 schließlich überprüft die eingeschriebenen Zeitpunkte auf ihre Richtigkeit hin.

Theoretisch kann eine richtige Pulsbreitenmodulation anhand der richtigen Lage dreier aufeinanderfolgender Flanken erkannt werden. Demzufolge kann die Auswerteeinrichtung 405 beispielsweise so ausgelegt sein, daß sie die jeweils drei jüngsten Einträge in der Speichereinrichtung 404 auf Richtigkeit auswertet und dann, wenn sie Fehler feststellt, ein Fehlersignal ausgibt, das gegebenenfalls mit den Fehlersignalen aus den Vergleichseinrichtung 407, 408 zu einem gemeinsamen Fehlersignal F, 411 kombiniert werden kann.

Um Fehlalarme zu vermeiden, kann es sinnvoll sein, auf die Feststellung einer ersten Unregelmäßigkeit hin weitere Gruppen von Flanken auf ihre zeitliche Lage hin zu untersuchen und erst dann, wenn hierbei mehrfach Fehler festgestellt werden, ein Fehlersignal auszugeben. Auch die Auswerteeinrichtung 405 kann über Leitung 412 Daten empfangen, die ihr benötigte Informationen mitteilen, beispielsweise das zu erwartende Tastverhältnis usw.

Das Durchführen der beschriebenen Überprüfung in der Signalüberwachungseinrichtung 236 kann davon abhängig gemacht werden, daß die Versorgungsspannung in definierten Bereich liegt. Nur dann ist sichergestellt, daß die Überprüfung der Signale P1, P2 auf ihren Pegel hin zu richtigen Ergebnissen führt, wenn die Schwellenwerte vergleichsweise knapp bzw. eng gesetzt sind.

Verarbeitungseinrichtung 235, Erzeugungseinrichtung 237 und Signalüberprüfungseinrichtung 236 können digitale Schaltungen sein, die auf unterschiedlichen Chips ausgebildet sind. Vorzugsweise können dabei Verarbeitungseinrichtung 235 und Signalüberprüfungseinrichtung 236 identische Chips sein, die teilweise redundant arbeiten, aber die weiter oben beschriebenen Maßnahmen unabhängig voneinander ausführen.

Der Modus 2 (beide Schalter geschlossen) dauert vorzugsweise weniger als 1 ms, weiter vorzugsweise weniger als 500 µs.

Die beschriebene Überprüfung wird vorzugsweise periodisch angestoßen. Die Überprüfung des ersten Steuersignals S1 kann beispielsweise einmal pro Sekunde oder öfter, vorzugsweise dreimal pro Sekunde oder öfter erfolgen. Das gleiche gilt für die Überprüfung der Beschaltung und des Stellglieds anhand der Testsignale P1, P2.

Eine Möglichkeit, das als pulsbreitenmoduliertes Signal ausgebildete erste Steuersignal S1 zu überprüfen, ist es, ein pulsbreitenmoduliertes Signal mit vorbestimmten Tastverhältnis (Verhältnis zwischen An-Zeiten und Aus-Zeiten) zu erzeugen, wobei auch die gesamte Zykluszeit vorbestimmt ist. Beispielsweise kann ein Test-Steuersignal mit einem Tastverhältnis von 33 % gesetzt werden, bei dem die An-Zeit 18 µs und die Aus-Zeit 36 µs beträgt. Wenn diese Zeiten vorbestimmt sind, muß der Signalüberprüfungseinrichtung nicht mitgeteilt werden, welche Werte zu erwarten sind. Genauso kann es aber wünschenswert sein, flexible Testsignale zu erzeugen. Vorzugsweise ist das erzeugte Test-Steuersignal S1 unsymmetrisch, hat also ein Tastverhältnis von ungleich 50 %. Vorzugsweise ist ferner eine Einrichtung vorzusehen, die sicherstellt, daß die Polarität des Signals richtig erkannt wird. Damit wird sichergestellt, daß nicht ein falsch erzeugtes Testsignal mit einem komplementären Tastverhältnis (beispielsweise 67 % anstatt 33 %) anhand der Flankenzeitpunkt als richtig erkannt wird.

Sofern einerseits die Überprüfung der Beschaltung und des Stellglieds anhand der Signale P1, P2 und andererseits die Überprüfung des Steuersignals S1 anhand des Signals P3 prinzipiell gemeinsam vorgesehen sind, können diese alternierend vorgenommen werden. So können beispielsweise nacheinander die Moden 0, 1,2 und 3 wie oben beschrieben eingestellt werden und innerhalb dieser Moden die jeweiligen Überprüfungen vorgenommen werden. Auch hier sind Wiederholfrequenzen größer 1 Hz, vorzugsweise größer 3 Hz wünschenswert. Wenn nicht alle der oben erwähnten Überprüfungen als notwendig angesehen werden, können einzelne oder mehrere Moden oder innerhalb dieser Moden verschiedene Prüfungsschritte weggelassen werden.

Wenn in einem der Moden ein Fehler festgestellt wird, deutet dies auf einen Fehler in der Beschaltung, im Stellglied oder in der Erzeugung des ersten Steuersignals hin. Dementsprechend sind entsprechende Gegenmaßnahmen zu veranlassen, beispielsweise Ausgabe eines Alarmsignals oder ähnliches.

Der Ablauf des Überprüfungsverfahrens kann durch einen (nicht gezeigten) Prozessor gesteuert sein. Anstelle in des in Figur 2 gezeigten diskreten Aufbaus der Beschaltung kann auch ein integrierter Aufbau, wie er durch Figur 1 angedeutet ist, vorgesehen sein.

## Patentansprüche

1. Elektrisch steuerbarer Bremskraftverstärker mit einem zwischen zwei Potentiale (101, 102) schaltbaren, mit zwei Anschlüssen (100a, b) versehenen Stellglied (100) sowie einer Beschaltung für das Stellglied (100), mit
- einer ersten und einer zweiten Leitung (104, 103), die die zwei Potentiale (101, 102) den Anschlüssen (100a, 100b) zuführen,
- einem in der ersten Leitung (104) vorgesehenen elektronisch betätigbaren ersten Schalter (106, 206) zwischen dem ersten Potential (102) und dem ersten Anschluß (100b) des Stellglieds, und
- einer Steuerungseinrichtung (112, 235 - 237), die den ersten Schalter (106, 206) mit einem ersten, vorzugsweise pulsbreitenmodulierten Steuersignal (S1) schaltet,
**gekennzeichnet durch**
einen in der zweiten Leitung (103) vorgesehenen elektronisch betätigbaren zweiten Schalter (105, 205) zwischen dem zweiten Potential (101) und dem zweiten Anschluß (100a) des Stellglieds, wobei die Steuerungseinrichtung den zweiten Schalter mit einem zweiten Steuersignal (S2) schaltet.

2. Elektrisch steuerbarer Bremskraftverstärker nach Anspruch 1, **dadurch gekennzeichnet, daß** für das erste Steuersignal (S1) eine erste Signalführung (109) zu einer Signalüberwachungseinrichtung (236) vorgesehen ist.

3. Elektrisch steuerbarer Bremskraftverstärker nach Anspruch 1 oder 2, **dadurch gekennzeichnet, daß** zwischen dem ersten Schalter (106, 206) und dem ersten Anschluß (100b) und/oder zwischen dem zweiten Schalter (105, 205) und dem zweiten Anschluß (100a) eine zweite Signalführung (107, 108, 221, 222, 224, 225) zu einer Signalüberwachungseinrichtung (236) vorgesehen ist.

4. Elektrisch steuerbarer Bremskraftverstärker nach einem der vorherigen Ansprüche, **dadurch gekennzeichnet, daß** die Steuerungseinrichtung (112, 235 - 237) ein pulsbreitenmoduliertes erstes Steuersignal erzeugt und eine Verarbeitungseinrichtung (235) aufweist, die nach Maßgabe von Eingangssignalen ein das Tastverhältnis der Pulsbreitenmodulation angebendes erstes Ausgangssignal (S1') erzeugt, und eine Erzeugungseinrichtung (237), die das erste Ausgangssignal empfängt und das erste Steuerungssignal (S1) ausgibt.

5. Elektrisch steuerbarer Bremskraftverstärker nach Anspruch 4, **dadurch gekennzeichnet, daß** die Signalüberwachungseinrichtung (236) eine mit der Verarbeitungseinrichtung (235) baugleiche und mit dieser Daten austauschende elektronische Schaltung ist.

6. Elektrisch steuerbarer Bremskraftverstärker nach Anspruch 4 oder 5, **dadurch gekennzeichnet, daß** die Verarbeitungseinrichtung (235) eine Testeinrichtung zum Erzeugen eines geeigneten ersten Ausgangssignals (S1') und eines geeigneten zweiten Steuerungssignals (S2) zum Überprüfen der Beschaltung und des Stellglieds und/oder des pulsbreitenmodulierten ersten Steuerungssignals (S1) aufweist.

7. Elektrisch steuerbarer Bremskraftverstärker nach Anspruch 2, **dadurch gekennzeichnet, daß** die Signalüberwachungseinrichtung (236) eine erste Prüfeinrichtung (401 - 406) zum Überwachen und/oder Beurteilen der Pegelwechsel des pulsbreitenmodulierten ersten Steuerungssignals aufweist.

8. Elektrisch steuerbarer Bremskraftverstärker nach einem der Ansprüche 2 bis 7, **dadurch gekennzeichnet, daß** die Signalüberwachungseinrichtung (236) eine zweite Prüfeinrichtung (407, 408) zum Überwachen und/oder Beurteilen der elektrischen Werte auf der zweiten Signalrückführung aufweist.

9. Elektrisch steuerbarer Bremskraftverstärker nach Anspruch 7, **dadurch gekennzeichnet, daß** die erste Prüfeinrichtung (401 - 406) je einen Flankendetektor (401, 402) für steigende und fallende Flanken eines digitalen Signals sowie eine Zeitmeßeinrichtung (403) aufweist.

10. Elektrisch steuerbarer Bremskraftverstärker nach Anspruch 9, **dadurch gekennzeichnet, daß** die erste Prüfeinrichtung (401 - 406) eine Speichereinrichtung (404) aufweist, in die die Zeitpunkte der detektierten Flanken seriell eingeschrieben werden, und eine Auswerteeinrichtung (405), die mindestens drei aufeinanderfolgende Einträge im Register auswertet.

11. Verfahren zum Überprüfen der Beschaltung eines zwischen zwei Potentiale schaltbares, mit zwei Anschlüssen versehenen Stellglieds eines elektronisch gesteuerten Bremskraftverstärkers sowie des Stellglieds selbst, wobei die Beschaltung Leitungen aufweist, die die zwei Potentiale von einem ersten und einem zweiten Bezugspunkt liefern, einen ersten Schalter zwischen dem ersten Bezugspunkt und dem ersten Anschluß des Stellglieds, und eine Steuerungseinrichtung, die den ersten mit einem vorzugsweise pulsbreitenmodulierten ersten Steuersignal schaltet, **dadurch gekennzeichnet, daß**
die Steuerungseinrichtung einen zweiten Schalter zwischen dem zweiten Bezugspunkt und dem zweiten Anschluß des Stellglieds mit einem pulsbreitenmodulierten zweiten Steuersignal schaltet, wobei zumindest ein Potential an zumindest einem Anschluß des Stellglieds überprüft wird, wenn beide Schalter offen sind. einem Anschluß des Stellglieds

12. Verfahren nach Anspruch 11, **gekennzeichnet durch** die weiteren Schritte
- Offenhalten des ersten Schalters und Schließen des zweiten Schalters, und
- Überprüfen zumindest eines Potentials an zumindest einem Anschluß des Stellglieds

13. Verfahren nach Anspruch 11 oder 12, **gekennzeichnet durch** die weiteren Schritte
- Schließen des zweiten Schalters und kurzzeitigen Schließen des ersten Schalters und
- Überprüfen zumindest eines Potentials an zumindest einem Anschluß des Stellglieds, während der erste Schalter geschlossen ist.

14. Verfahren nach Anspruch 13, **dadurch gekennzeichnet, daß** der erste Schalter weniger als 1 ms, vorzugsweise weniger als 500 µs geschlossen gehalten wird.

15. Verfahren nach einem der vorherigen Ansprüche, **dadurch gekennzeichnet, daß** die Potentiale an beiden Anschlüssen des Stellglieds überprüft werden.

16. Verfahren nach einem der vorherigen Ansprüche, **dadurch gekennzeichnet, daß** bei der Überprüfung eines Potentials dieses mit einem Schwellenwert verglichen wird.

17. Verfahren zum Überprüfen eines pulsbreitenmodulierten ersten Steuersignals für ein zwischen zwei Potentiale schaltbares, mit zwei Anschlüssen versehenes Stellglied eines elektronisch gesteuerten Bremskraftverstärkers, wobei die Beschaltung des Stellglieds Leitungen aufweist, die die zwei Potentiale von einem ersten und einem zweiten Bezugspunkt liefern, mit einem ersten Schalter zwischen dem ersten Bezugspunkt und dem ersten Anschluß des Stellglieds, und einer Steuerungseinrichtung, die den ersten Schalter mit einem pulsbreitenmodulierten ersten Steuersignal schaltet,
**dadurch gekennzeichnet, daß** die Steuerungseinrichtung einen zweiten Schalter zwischen dem zweiten Bezugspunkt und dem zweiten Anschluß des Stellglieds mit einem pulsbreitenmodulierten zweiten Steuersignal schaltet, wobei der zweite Schalter offengehalten wird,
die Erzeugung des pulsbreitenmodulierten ersten Steuersignals mit einem bestimmten Tastverhältnis veranlaßt wird, und die zeitlichen Verhältnisse zwischen mehreren Flanken des erzeugten ersten Steuersignals überprüft werden und ein Fehlersignal ausgegeben wird, wenn keine Sollverhältnisse vorliegen.

18. Verfahren nach Anspruch 17, **dadurch gekennzeichnet, daß** die zeitlichen Verhältnisse zwischen drei aufeinanderfolgenden Flanken des erzeugten ersten Steuersignals überprüft werden.

19. Verfahren nach Anspruch 17 oder 18, **dadurch gekennzeichnet, daß** zunächst die zeitlichen Verhältnisse zwischen Flanken einer ersten Gruppe von Flanken des erzeugten ersten Steuersignals überprüft werden und dann, wenn hier keine Sollverhältnisse vorliegen, die zeitlichen Verhältnisse zwischen Flanken zumindest einer zweiten Gruppe von Flanken des erzeugten ersten Steuersignals überprüft werden und dann, wenn auch hier keine Sollverhältnisse vorliegen, das Fehlersignal ausgegeben wird.

## Claims

1. An electrically controlled brake force booster comprising an actuator (100) that can be connected between two potentials (101, 102) and has two connections (100a, b) as well as a circuit arrangement for the actuator (100), which comprises
- a first and a second line (104, 103) which supply the two potentials (101, 102) to the connections (100a, 100b),
- an electronically actuated first switch (106, 206) provided in the first line (104) between the first potential (102) and the first connection (100b) of the actuator, and
- a control device (112, 235-237) that switches the first switch (106, 206) with a first, preferably pulse-width modulated control signal (S1),
**characterized by**
an electronically actuated second switch (105, 205) that is provided in the second line (103) between the second potential (101) and the second connection (100a) of the actuator, with the control device switching the second switch with a second control signal (S2).

2. An electrically controlled brake force booster according to Claim 1, **characterized in that** a first signal line (109) for leading the first control signal (S1) to a signal monitoring device (236) is provided.

3. An electrically controlled brake force booster according to Claim 1 or 2, **characterized in that** a second signal line (107, 108, 221, 222, 224, 225) leading to a signal monitoring device (236) is provided between the first switch (106, 206) and the first connection (100b) and/or the second switch (105, 205) and the second connection (100a).

4. An electrically controlled brake force booster according to one of the preceding claims, **characterized in that** the control device (112, 235-237) generates a pulse-width modulated first control signal and includes a processing device (235) that generates a first output signal (S1') that indicates the pulse width ratio of the pulse-width modulation in accordance with input signals and a generation device (237) that receives the first output signal and outputs the first control signal (S1).

5. An electrically controlled brake force booster according to Claim 4, **characterized in that** the signal monitoring device (236) is an electronic circuit that has the same design as the processing device (235) and can exchange data with it.

6. An electrically controlled brake force booster according to Claim 4 or 5, **characterized in that** the processing device (235) exhibits a testing device for generating a suitable first output signal (S1') and a suitable second control signal (S2) for testing the circuit arrangement and the actuator and/or the pulse-width modulated first control signal (S1).

7. An electrically controlled brake force booster according to Claim 2, **characterized in that** the signal monitoring device (236) includes a first testing device (401-406) for monitoring and/or evaluating the state changes of the pulse-width modulated first control signal.

8. An electrically controlled brake force booster according to one of claims 2 to 7, **characterized in that** the signal monitoring device (236) comprises a second testing device (407, 408) for monitoring and/or evaluating the electric values on the second signal feedback.

9. An electrically controlled brake force booster according to Claim 7, **characterized in that** the first testing device (401-406) exhibits one edge detector (401, 402) respectively for leading and trailing edges of a digital signal as well as a timing device (403).

10. An electrically controlled brake force booster according to Claim 9, **characterized in that** the first testing device (401-406) exhibits a memory (404), into which the instants of the detected edges are written serially, and an evaluation device (405) that evaluates at least three successive entries in the register.

11. A process for testing the circuit arrangement of an actuator of an electronically controlled brake force booster, which can be connected between two potentials and has two connections, as well as the actuator itself, wherein the circuit arrangement exhibits lines that supply the two potentials from a first and a second reference point, a first switch between the first reference point and the first connection of the actuator, and a control device that switches the first switch preferably with a pulse-width modulated first control signal, **characterized in that** the control device switches a second switch between the second reference point and the second connection of the actuator with a pulse-width modulated second control signal, wherein at least one potential on at least one connection of the actuator is tested when both switches are open.

12. A process according to Claim 11, **characterized by** the following steps:
- keeping open the first switch and closing the second switch, and
- checking at least one potential on at least one connection of the actuator.

13. A process according to Claim 11 or 12, **characterized by** the additional steps:
- closing the second switch and closing the first switch briefly, and
- checking at least one potential on at least one connection of the actuator while the first switch is closed.

14. A process according to Claim 13, **characterized in that** the first switch is kept closed less than 1 ms, preferably less than 500µs.

15. A process according to one of the preceding claims, **characterized in that** the potentials on both connections of the actuator are checked.

16. A process according to one of the preceding claims, **characterized in that** the potential being tested is compared with a threshold value.

17. A process for testing a pulse-width modulated first control signal for an actuator of an electronically controlled brake force booster that can be connected between two potentials and has two connections, wherein the circuit arrangement of the actuator exhibits lines that supply two potentials from a first and a second reference point, with a first switch between the first reference point and the first connection of the actuator, and a control device that switches the first switch with a pulse-width modulated first control signal, **characterized in that** the control device switches a second switch between the second reference point and the second connection of the actuator with a pulse-width modulated second control signal, wherein the second switch is held open, the generation of the pulse-width modulated first control signal with a defined pulse width ratio is caused, and the time-related ratios between several edges of the generated first control signal are checked and a fault signal is emitted if the desired states are not detected.

18. A process according to Claim 17, **characterized in that** the time-related ratios between three successive edges of the generated first control signal are checked.

19. A process according to Claim 17 or 18, **characterized in that** at first the time-related ratios between edges of a first group of edges of the generated first control signal are checked and then, if no desired states are detected, the time-related ratios between the edges of at least one second group of edges of the generated first control signal are checked and then, if no desired states are detected here either, the fault signal is output.

## Revendications

1. Amplificateur de force de freinage à commande électrique comprenant un élément de réglage (100), pouvant être commuté entre deux potentiels (101, 102) et pourvu de deux bornes (100a, b), et une connexion pour l'élément de réglage (100), comprenant
- une première et une seconde lignes (104, 103) qui appliquent les deux potentiels (101, 102) aux bornes (100a, 100b),
- un premier interrupteur à commande électronique (106, 206) prévu dans la première ligne (104) et situé entre le premier potentiel (102) et la première borne (100b) de l'élément de réglage, et
- un dispositif de commande (112, 235 - 237) qui fait commuter le premier interrupteur (106, 206) par un premier signal de commande (S1), de préférence à modulation en largeur d'impulsion,
**caractérisé par**
un second interrupteur à actionnement électronique (105, 205) prévu dans la seconde ligne (103) et situé entre le second potentiel (101) et la seconde borne (100a) de l'élément de réglage, le dispositif de commande faisant commuter le second interrupteur par un second signal de commande (S2).

2. Amplificateur de force de freinage à commande électrique suivant la revendication 1, **caractérisé en ce qu'**il est prévu un premier guidage de signal (109) vers un dispositif de surveillance de signal (236) pour le premier signal de commande (S1).

3. Amplificateur de force de freinage à commande électrique suivant la revendication 1 ou 2, **caractérisé en ce qu'**un second guidage de signal (107, 108, 221, 222, 224, 225) vers un dispositif de surveillance de signal (236) est prévu entre le premier interrupteur (106, 206) et la première borne (100b) et/ou entre le second interrupteur (105, 205) et la seconde borne (100a).

4. Amplificateur de force de freinage à commande électrique suivant l'une des revendications précédentes, **caractérisé en ce que** le dispositif de commande (112, 235 - 237) produit un premier signal de commande à modulation en largeur d'impulsion et comprend des moyens de traitement (235), qui en fonction de signaux d'entrée, produisent un premier signal de sortie (S1') fournissent le rapport durée d'impulsion/intervalle entre impulsions de la modulation en largeur d'impulsion, et des moyens de production (237) qui reçoivent le premier signal de sortie et délivrent le premier signal de commande (S1).

5. Amplificateur de force de freinage à commande électrique suivant la revendication 4, **caractérisé en ce que** le dispositif de surveillance de signal (236) est un circuit électronique de même structure que les moyens de traitement (235) et échangeant des données avec ceux-ci.

6. Amplificateur de force de freinage à commande électrique suivant la revendication 4 ou 5, **caractérisé en ce que** les moyens de traitement (235) comprennent un dispositif de test servant à produire un premier signal de sortie (S1') approprié et un second signal de commande (S2) approprié servant à vérifier la connexion et l'élément de réglage et/ou le premier signal de commande à modulation en largeur d'impulsion (S1).

7. Amplificateur de force de freinage à commande électrique suivant la revendication 2, **caractérisé en ce que** le dispositif de surveillance de signal (236) comprend des premiers moyens de contrôle (401 - 406) servant à surveiller et/ou décider du changement de niveau du premier signal de commande à modulation en largeur d'impulsion.

8. Amplificateur de force de freinage à commande électrique suivant l'une des revendications 2 à 7, **caractérisé en ce que** le dispositif de surveillance de signal (236) comprend des seconds moyens de contrôle (407, 408) servant à surveiller et/ou décider des valeurs électriques sur le second retour de signal.

9. Amplificateur de force de freinage à commande électrique suivant la revendication 7, **caractérisé en ce que** les premiers moyens de contrôle (401 - 406) comprennent deux détecteurs de flanc (401, 402), respectivement pour les flancs montants et les flancs descendants d'un signal numérique, et un dispositif de mesure de temps (403).

10. Amplificateur de force de freinage à commande électrique suivant la revendication 9, **caractérisé en ce que** les premiers moyens de contrôle (401 - 406) comprennent un dispositif de mémoire (404), dans lequel les instants des flancs détectés sont inscrits en série, et un dispositif d'analyse (405) qui analyse au moins trois entrées se suivant dans le registre.

11. Procédé pour la vérification de la connexion d'un élément de réglage, pouvant être commuté entre deux potentiels et pourvue de deux bornes, d'un amplificateur de force de freinage à commande électronique, et de l'élément de réglage lui-même, la connexion comprenant des lignes qui fournissent les deux potentiels à partir d'un premier et d'un second points de référence, un premier interrupteur entre le premier point de référence et la première borne de l'élément de réglage, et un dispositif de commande qui fait commuter le premier interrupteur par un premier signal de commende de préférence à modulation en largeur d'impulsion, **caractérisé en ce que**
le dispositif de commande fait commuter un second interrupteur, situé entre le second point de référence et la seconde borne de l'élément de réglage, par un second signal de commande modulé en largeur d'impulsion, tandis qu'au moins un potentiel sur au moins une borne de l'élément de réglage est vérifié lorsque les deux interrupteurs sont ouverts.

12. Procédé suivant la revendication 11, **caractérisé par** les autres opérations :
- maintien ouvert du premier interrupteur et fermeture du second interrupteur et
- vérification d'au moins un potentiel sur au moins une borne de l'élément de réglage.

13. Procédé suivant la revendication 11 ou 12, **caractérisé par** les autres opérations
- fermeture du second interrupteur et fermeture brève du premier interrupteur et
- vérification d'au moins un potentiel sur au moins une borne de l'élément de réglage, alors que le premier interrupteur est fermé.

14. Procédé suivant la revendication 13, **caractérisé en ce que** le premier interrupteur est maintenu fermé moins de 1 ms, de préférence moins de 500 µs.

15. Procédé suivant l'une des revendications précédentes, **caractérisé en ce que** le potentiel sur les deux bornes de l'élément de réglage est vérifié.

16. Procédé suivant l'une des revendications précédentes, **caractérisé en ce que**, lors de la vérification d'un potentiel, celui-ci est comparé à une valeur de seuil.

17. Procédé pour la vérification d'un premier signal de commande à modulation en largeur d'impulsions pour un élément de réglage, pouvant être commuté entre deux potentiels et pourvue de deux bornes, d'un amplificateur de force de freinage à commande électronique, la connexion de l'organe de réglage comprenant des lignes qui fournissent les deux potentiels à partir d'un premier et d'un second points de référence, avec un premier interrupteur entre le premier point de référence et la première borne de l'élément de réglage, et un dispositif de commande qui fait commuter le premier interrupteur par un premier signal de commande à modulation en largeur d'impulsion,
**caractérisé en ce que**
le dispositif de commande fait commuter un second interrupteur, situé entre le second point de référence et la seconde borne de l'élément de réglage, par un second signal de commande modulé en largeur d'impulsion, le second interrupteur étant maintenu ouvert, un rapport durée d'impulsion/intervalle entre impulsions déterminé est imposé à la production du premier signal de commande à modulation en largeur d'impulsion, et les rapports dans le temps entre plusieurs flancs du premier signal de commande produit sont vérifiés et un signal d'erreur est délivré lorsqu'un rapport de consigne n'est pas présent.

18. Procédé suivant la revendication 17, **caractérisé en ce que** les rapports dans le temps entre trois flancs se suivant du premier signal de commande produits sont vérifiés.

19. Procédé suivant la revendication 17 ou 18, **caractérisé en ce que**, d'abord, les rapports dans le temps entre des flancs d'un premier groupe de flancs du premier signal de commande produit sont vérifiés, et, lorsqu'à cette occasion, un rapport de consigne n'est pas présent, les rapports dans le temps entre des flancs d'au moins un second groupe de flancs du premier signal de commande produit sont vérifiés et, lorsqu'également à cette occasion, un rapport de consigne n'est pas présent, le signal d'erreur est délivré.
